(19) Europäisches Patentamt
European Patent Office
Office européen des brevets

(11) **EP 4 750 298 A1**

(12) **EUROPEAN PATENT APPLICATION**

(43) Date of publication:
**27.05.2026 Bulletin 2026/22**

(21) Application number: **25218282.9**

(22) Date of filing: **25.11.2025**

(51) International Patent Classification (IPC):
**H10K 85/50** (2023.01)      **H10K 30/40** (2023.01)
**H10K 30/50** (2023.01)

(52) Cooperative Patent Classification (CPC):
**H10K 85/50; H10K 30/40; H10K 30/50**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **26.11.2024 KR 20240170589**

(71) Applicant: **Hansol Chemical Co., Ltd.**
**Gangnam-gu**
**Seoul 06169 (KR)**

(72) Inventors:
• **JEONG, Gyu Jeong**
  **55321 WANJU-GUN, JEOLLABUK-DO (KR)**

• **JANG, Eun Pyo**
  **55321 WANJU-GUN, JEOLLABUK-DO (KR)**
• **HA, Su Ryung**
  **55321 WANJU-GUN, JEOLLABUK-DO (KR)**
• **NOH, Jae Hong**
  **55321 WANJU-GUN, JEOLLABUK-DO (KR)**
• **KIM, Kyung Nam**
  **55321 WANJU-GUN, JEOLLABUK-DO (KR)**
• **HA, Sung Min**
  **55321 WANJU-GUN, JEOLLABUK-DO (KR)**

(74) Representative: **Cabinet Beau de Loménie**
**103, rue de Grenelle / CS 90800**
**75340 Paris Cedex 07 (FR)**

(54) **METHOD OF PREPARING REPROCESSED PEROVSKITE COMPOUND, REPROCESSED PEROVSKITE COMPOUND PREPARED THEREBY, PEROVSKITE DEVICE AND SOLAR CELL COMPRISING THE SAME**

(57) A method of preparing a reprocessed perovskite compound, a reprocessed perovskite compound prepared thereby, and a perovskite device and a solar cell including the same. The preparation method can reduce the manufacturing cost of products in which a perovskite device is used by restoring a degraded perovskite compound, and can minimize environmental pollution associated with disposal of perovskite compounds containing heavy metals. Furthermore, high-quality perovskite devices and solar cells can be provided by using the reprocessed perovskite compound prepared by the preparation method.

FIG. 2

EP 4 750 298 A1

**Description**

**CROSS-REFERENCE TO RELATED APPLICATION**

This patent document claims the benefit of Korean Patent Application No. 10-2024-0170589, filed on November 26, 2024, the entire disclosure of which is incorporated by reference for all purposes as if fully set forth herein.

**TECHNICAL FIELD**

The present invention relates to a method of reprocessing a degraded perovskite compound, a reprocessed perovskite compound prepared thereby, and a perovskite device and a solar cell including the same.

**BACKGROUND**

Perovskite compounds are widely used in various applications, such as solar cells, light emitting diodes (LEDs), and optoelectronic devices, due to excellent physical and chemical properties thereof. However, when stored for a long period of time, perovskite compounds can undergo physical and chemical changes depending on environmental conditions, which can negatively affect the performance and stability of perovskite devices. Therefore, for commercialization of perovskite devices, it is particularly important to solve the problem of degradation in performance resulting from large-scale production and long-term storage of perovskite compounds.

Specifically, during long-term storage, perovskite materials can undergo changes in crystal structure, reduction in particle size, or reduction in stability of a crystal phase due to ambient conditions, such as moisture, oxygen, heat, and light. These changes can cause degradation in performance of perovskite devices. However, since it is impossible to completely shield perovskite materials from ambient conditions during storage, it is practically difficult to fundamentally prevent degradation resulting from long-term storage. Considering this, a new strategy is required to minimize performance degradation of perovskite devices resulting from long-term storage and to ensure consistent quality of perovskite materials.

In addition, perovskite materials typically contain heavy metals such as lead, which can cause environmental pollution upon disposal. Although new methods have been developed in recent years to synthesize heavy metal-free perovskite materials, such as lead-free perovskite materials, many high-performance perovskite devices are still prepared using heavy metal-based perovskite materials due to low performance of the former.

Therefore, there is a need for a method that can restore the performance of perovskite materials degraded due to long-term storage to the initial state thereof for reuse, thereby minimizing environmental pollution resulting from disposal of degraded perovskite materials.

**SUMMARY**

Embodiments of the present invention have been conceived to solve such problems in the art and it is an aspect of the present invention to provide a method of preparing a reprocessed perovskite compound with restored performance by restoring a degraded perovskite compound.

It is another aspect of the present invention to provide a method that can further enhance the performance of a reprocessed perovskite compound by precisely controlling addition of an organic cation precursor during reprocessing of a degraded perovskite compound.

It is a further aspect of the present invention to provide a method that can minimize environmental pollution by restoring a degraded perovskite compound instead of discarding the degraded perovskite compound.

It is still another aspect of the present invention to provide a reprocessed perovskite compound prepared by the method, and a perovskite device and a solar cell comprising the same.

However, it should be understood that aspects of the present invention are not limited to those described above. The above and other aspects of the present invention will become apparent to those skilled in the art from the detailed description of the following embodiments in conjunction with the accompanying drawings.

In accordance with one aspect of the present invention, there is provided a method of preparing a reprocessed perovskite compound, including: (a) determining a weight loss of a degraded perovskite compound; (b) preparing a mixture by mixing the degraded perovskite compound with a solvent; and (c) reprocessing the degraded perovskite compound by heating the mixture prepared in step (b), wherein, when the weight loss of the degraded perovskite compound as determined in step (a) is greater than or equal to a reference value, step (b) comprises further adding 50 wt% to 180 wt% of an organic cation precursor relative to the weight loss.

The perovskite compound may be an organic ammonium-based perovskite compound.

The organic ammonium-based perovskite compound may be a compound represented by Formula 1:

AMX$_3$,

where A is formamidinium (FA), methylammonium (MA), FA$_x$MA$_{(1-x)}$ (0<x<1), or N(R$^1$)4$^+$,
R$^1$ being a linear C$_1$ to C$_5$ alkyl group, a branched C$_3$ to C$_5$ alkyl group, a phenyl group, an alkylphenyl group, or an alkoxyphenyl group;
M is a divalent metal cation; and
X is a halogen anion.

The degraded perovskite compound may have a weight loss of 1 wt% or more relative to the weight of the perovskite compound immediately after synthesis.

The reference value may be selected within a range of 6% to 10% of the weight of the perovskite compound immediately after synthesis.

In step (a), the weight loss may be determined by thermogravimetric analysis (TGA).

The organic cation precursor may be an organic ammonium compound.

The organic ammonium compound may be a compound represented by Formula 2:

AX,

where A is formamidinium (FA), methylammonium (MA), FA$_x$MA$_{(1-x)}$ (0<x<1), or N(R$^1$)4$^+$,
R$^1$ being a linear C$_1$ to C$_5$ alkyl group, a branched C$_3$ to C$_5$ alkyl group, a phenyl group, an alkylphenyl group, or an alkoxyphenyl group; and
X is a halogen anion.

Step (c) may be performed at a temperature of 30°C to 300°C for 10 min to 180 min.

In accordance with another aspect of the present invention, there is provided a reprocessed perovskite compound prepared by the method set forth above.

In accordance with a further aspect of the present invention, there is provided a perovskite device including the reprocessed perovskite compound set forth above.

In accordance with yet another aspect of the present invention, there is provided a solar cell including the perovskite device set forth above.

The method of preparing a reprocessed perovskite compound according to the present invention can reduce the manufacturing cost of a product in which a perovskite device is used by restoring a degraded perovskite compound to prepare a reprocessed perovskite compound with restored performance and using the reprocessed perovskite compound in manufacture of a perovskite device.

In addition, the method according to the present invention can prevent waste of raw materials required for reprocessing and can further enhance the performance of the reprocessed perovskite compound by precisely analyzing a degradation state of a degraded perovskite compound to accurately determine whether to add an organic cation precursor and how much organic cation precursor to add.

In addition, the method according to the present invention can minimize environmental pollution resulting from disposal of heavy metal-containing perovskite compounds by restoring degraded perovskite compounds instead of discarding the degraded perovskite compounds.

In addition, the reprocessed perovskite compound prepared by the method according to the present invention can be effectively used in manufacture of high-quality perovskite devices and solar cells since the performance thereof can be restored to a level equivalent to that of a perovskite compound before degradation.

**BRIEF DESCRIPTION OF DRAWINGS**

The above and other aspects, features, and advantages of the present invention will become apparent from the detailed description of the following embodiments in conjunction with the accompanying drawings:

FIG. 1 is a schematic diagram illustrating a method for synthesizing a perovskite compound;
FIG. 2 is a schematic diagram illustrating a method of preparing a reprocessed perovskite compound according to the present invention;
FIG. 3 is a digital image showing the results of inducing degradation of a perovskite compound by exposing the perovskite compound to high temperature/high humidity conditions for 0 hr (pristine), 1 hr, 24 hr, 48 hr, 72 hr, and 100 hr, respectively;
FIG. 4 is a graph depicting the results of X-Ray diffraction (XRD) analysis, as determined after exposing a perovskite compound to high temperature/high humidity conditions for 0 hr (pristine), 1 hr, 24 hr, 48 hr, 72 hr, and 100 hr, respectively;

FIG. 5 is a graph depicting the results of thermogravimetric analysis (TGA), as determined after exposing a perovskite compound to high temperature/high humidity conditions for 0 hr (pristine), 1 hr, 24 hr, 48 hr, 72 hr, and 100 hr, respectively;

FIG. 6 is a graph depicting the results of measuring the photocurrent-voltage (J-V) characteristics of perovskite devices prepared using perovskite compounds exposed to high temperature/high humidity conditions for 0 hr (pristine), 1 hr, 24 hr, 48 hr, 72 hr, and 100 hr, respectively;

FIG. 7 and FIG. 8 are graphs depicting the XRD analysis results of perovskite compounds or reprocessed perovskite compounds according to Preparative Examples, Examples, and Comparative Examples;

FIG. 9 and FIG. 10 are scanning electron microscopy (SEM) images of perovskite compounds or reprocessed perovskite compounds according to Preparative Examples, Examples, and Comparative Examples; and

FIG. 11 and FIG. 12 are graphs depicting the results of measuring the photocurrent-voltage (J-V) characteristics of perovskite devices prepared using perovskite compounds or reprocessed perovskite compounds according to Preparative Examples, Examples, and Comparative Examples.

## DETAILED DESCRIPTION

Unless otherwise defined herein, all terms including technical or scientific terms used herein have the same meanings as commonly understood by those skilled in the art to which the present invention belongs. It will be further understood that terms, such as those defined in commonly used dictionaries, should be interpreted as having a meaning that is consistent with their meaning in the context of the specification and relevant art and should not be interpreted in an idealized or overly formal sense unless expressly so defined herein.

It will be further understood that the terms "comprises" and/or "comprising," when used in this specification, specify the presence of stated features, steps, operations, elements, and/or components, but do not preclude the presence or addition of one or more other features, steps, operations, elements, components, and/or groups.

A method of preparing a reprocessed perovskite compound according to the present invention includes recovering a degraded perovskite compound and reprocessing the recovered perovskite compound for reuse. Prior to describing the preparation method according to the invention, a perovskite compound to be reprocessed will be described.

<Perovskite compound>

A perovskite compound generally refers to a compound having an $ABX_3$ nanocrystalline structure and may be used as a light-emitting material for LEDs or a light-absorbing material for solar cells. Generally, A is an organic or inorganic monovalent cation, B is a divalent cation and X is a halide ion.

In one embodiment, the perovskite compound may be an organic ammonium-based perovskite compound, wherein the organic ammonium-based perovskite compound may be a compound represented by Formula 1:

$$AMX_3,$$

where A is formamidinium (FA), methylammonium (MA), $FA_xMA_{(1-x)}$ (where 0<x<1), or $N(R^1)4^+$, $R^1$ being a linear $C_1$ to $C_5$ alkyl group, a branched $C_3$ to $C_5$ alkyl group, a phenyl group, an alkylphenyl group, or an alkoxyphenyl group.

In addition, in Formula 1, M is a divalent metal cation and X is a halogen anion.

The divalent metal cation may include $Fe^{2+}$, $Co^{2+}$, $Ni^{2+}$, $Bi^{2+}$, $Ti^{2+}$, $Eu^{2+}$, $Zr^{2+}$, $Pb^{2+}$, $Cu^{2+}$, $Sn^{2+}$, or $Ge^{2+}$.

The halogen anion may include $F^-$, $Cl^-$, $Br^-$, $I^-$, or a mixture thereof.

The perovskite compound having an $AMX_3$ nanocrystalline structure may be prepared, for example, by preparing precursor solutions including A, M, and X, respectively, followed by mixing and reacting the prepared precursor solutions.

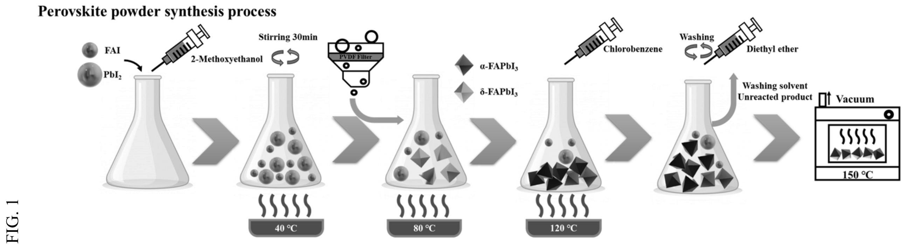

FIG. 1 is a schematic diagram illustrating a method of synthesizing a perovskite compound. In the following, a method of synthesizing a formamidinium-based perovskite compound (formamidinium lead iodide ($FAPbI_3$)) will be described as an example with reference to FIG. 1.

(1) Preparation of precursor solution

A precursor solution is prepared by placing lead iodide ($PbI_2$) and formamidinium iodide (FAI) as precursors for the formamidinium-based perovskite compound in a solvent, followed by mixing.

The solvent may include any solvent that can dissolve the precursors, for example, 2-methoxyethanol (2-ME).

To enhance solubility of the precursors, the precursor solution may be prepared by placing the precursors in the solvent, followed by mixing under heating for a predetermined period of time. For example, mixing of the precursors may be carried out at 40°C for 30 minutes.

(2) Synthesis of perovskite compound

The prepared precursor solution is heated to synthesize a perovskite compound. Here, the prepared precursor solution may be heated to a temperature of 80°C to 180°C, preferably 120°C. In addition, the prepared precursor solution may be reacted for 15 min to 180 min, preferably for 30 min.

To ensure more efficient synthesis reaction, the precursor solution may be filtered through a filter prior to synthesis of the perovskite compound to remove any undissolved precursor particles. Here, the filter may include a polyvinylidene difluoride (PVDF) filter, without being limited thereto.

(3) Precipitation of perovskite compound

An antisolvent is added to the solution containing the synthesized perovskite compound to precipitate the perovskite compound. Using the properties of the solvent and the antisolvent, separation and precipitation of the synthesized perovskite compound from the resulting reaction solution are induced. Separation of the synthesized perovskite compound may be carried out by any typical liquid-solid separation method known in the art, for example, centrifugation.

The antisolvent may include any antisolvent that can precipitate the perovskite compound due to a polarity difference with the solvent, for example, chlorobenzene.

(4) Obtainment of perovskite compound

The precipitated perovskite compound is washed, separated by filtration, and dried to evaporate the solvent, thereby obtaining a perovskite compound (formamidinium lead iodide ($FAPbI_3$)).

The precipitated perovskite compound may be washed using an antisolvent, for example, diethyl ether, without being limited thereto.

Drying of the precipitated perovskite compound may be carried out under a vacuum and, if necessary, may involve heating to accelerate evaporation of the solvent.

<Method of preparing reprocessed perovskite compound>

Perovskite compounds can be degraded during storage as a portion of a perovskite nanocrystalline structure is liberated and lost in the form of a precursor, is transformed into another phase without light-absorption properties, or is transformed into other byproducts due to ambient conditions, such as moisture, oxygen, heat, and light. Such degradation of the perovskite compound is manifested as a reduction in weight thereof.

Such a degraded perovskite compound also suffers from degradation in performance as an initial perovskite nanocrystalline structure thereof is lost or transformed. Accordingly, to restore the performance of the degraded perovskite compound, the lost or transformed perovskite nanocrystalline structure needs to be restored to the initial state thereof.

To this end, the method of preparing a reprocessed perovskite compound according to the present invention includes: (a) determining a weight loss of a degraded perovskite compound; (b) preparing a mixture by mixing the degraded perovskite compound with a solvent; and (c) reprocessing the degraded perovskite compound by heating the mixture prepared in step (b).

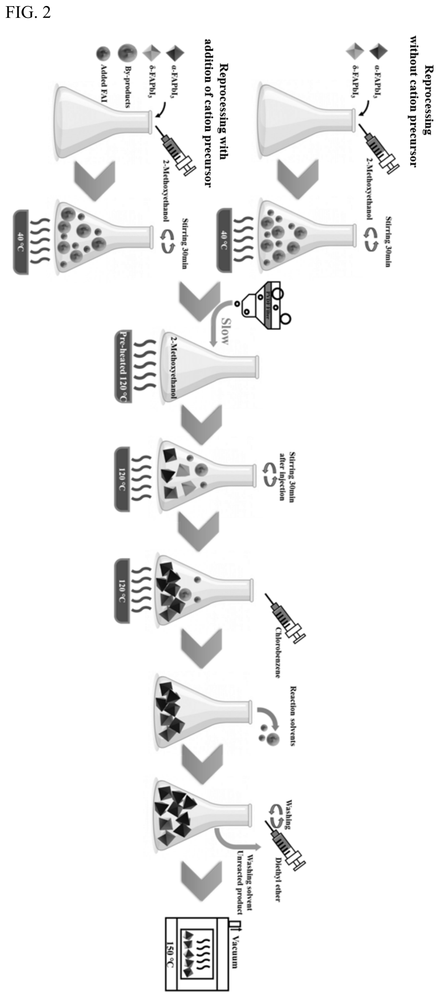

FIG. 2 is a schematic diagram illustrating the method of preparing a reprocessed perovskite compound according to the present invention. Now, the method of preparing a reprocessed perovskite compound according to the present invention will be described with reference to FIG. 2.

Herein, the reprocessed perovskite compound refers to a perovskite compound obtained by reprocessing a degraded perovskite compound as a starting material and is different from a perovskite compound freshly synthesized using the precursor solution (see <Perovskite compound>) as a starting material.

A reprocessed perovskite may refer to a perovskite compound having a weight loss that is lower than the weight loss of the degraded perovskite.

According to one embodiment, a perovskite compound having a $ABX_3$ nanocrystalline structure where A is an organic or inorganic monovalent cation, B is a divalent cation and X is a halide ion, may be obtained by reacting precursor solutions including an organic monovalent cation precursor, a divalent cation precursor, and a halide ion precursor. A perovskite compound (that is obtained by reacting precursor solutions) may be exposed to ambient conditions during storage and may transform into a degraded perovskite compound. A degraded perovskite compound may be defined as a perovskite compound having a weight loss of 1 wt% or more relative to the weight of the perovskite compound as measured immediately after synthesis. The weight loss of a perovskite compound may refer to a weight loss of an organic cation precursor-derived structure within the perovskite compound.

Herein, the expression "immediately after synthesis" means an initial state of a perovskite compound freshly synthesized using the precursor solution as a starting material and is different from the initial state of the reprocessed perovskite compound. A weight loss of the perovskite compound may refer to a weight loss of A which derives from the reaction of an organic cation precursor-derived within the perovskite compound using TGA

(a) Step of determining a weight loss of a degraded perovskite compound

As described above, upon degradation of a perovskite compound, the weight of the perovskite compound is decreased compared to the weight thereof immediately after synthesis. Accordingly, the degree of degradation of the perovskite compound can be identified by determining a weight loss of the perovskite compound relative to the weight thereof immediately after synthesis.

Herein, the degraded perovskite compound may refer to a perovskite compound with a weight loss of 1% by weight (wt%) or more relative to the weight thereof immediately after synthesis. If the weight loss of a perovskite compound is less than 1 wt% relative to the weight thereof immediately after synthesis, the corresponding perovskite compound may still retain initial performance thereof and may not need to be reprocessed.

The degraded perovskite compound to be reprocessed may be an organic ammonium-based perovskite compound, wherein the organic ammonium-based perovskite compound may be a compound represented by Formula 1.

A weight loss of the degraded perovskite compound may be determined by thermogravimetric analysis (TGA).

Determination of the weight loss may include determining a weight loss of an organic cation precursor-derived structure within the perovskite compound using TGA. Since an organic cation precursor used in synthesis of the organic ammonium-based perovskite compound is volatile, a portion of the organic cation precursor liberated from a perovskite nanocrystalline structure during a degradation process may be lost. Accordingly, by determining the weight loss of the organic cation precursor-derived structure within the perovskite compound using TGA, it is possible to determine whether to further add the organic cation precursor during reprocessing and how much organic cation precursor to further add.

(b) Step of preparing a mixture by mixing the degraded perovskite compound with a solvent

The degraded perovskite compound to be reprocessed is mixed with a solvent to prepare a mixture.

In preparation of the mixture, it is determined whether to further add the organic cation precursor based on whether the weight loss of the degraded perovskite compound as determined in step (a) is greater than or equal to a reference value.

More specifically, when the weight loss of the degraded perovskite compound is greater than or equal to the reference value, the organic cation precursor may be further added to the solvent during preparation of the mixture to supplement the lost organic cation precursor prior to reprocessing.

The amount of the organic cation precursor further added may be in the range of 50 wt% to 180 wt%, preferably 75 wt% to 150 wt%, more preferably 90 wt% to 120 wt%, relative to the weight loss. Within this range, a crystal structure of the reprocessed perovskite compound can be successfully restored to the initial state immediately after synthesis, thereby allowing the reprocessed perovskite compound to exhibit performance similar to initial performance thereof.

Conversely, when the weight loss of the degraded perovskite compound is less than the reference value, the mixture may be prepared without further adding the organic cation precursor to the solvent since a loss of the organic cation precursor is not significant. If the organic cation precursor is further added when the weight loss of the degraded perovskite compound is less than the reference value, an excess of the organic cation precursor can be present in the resulting reaction mixture, making it difficult to ensure that the crystal structure of the reprocessed perovskite compound is successfully restored to the initial state immediately after synthesis.

The reference value for determining whether to further add the organic cation precursor may be in the range of 6% to 10% of the weight of the perovskite compound immediately after synthesis, preferably in the range of 7% to 9% of the weight of the perovskite compound immediately after synthesis, more preferably 8% of the weight of the perovskite compound immediately after synthesis. When the reference value is selected within this range, it is possible to prevent the organic cation precursor from being insufficiently or excessively present in the resulting reaction mixture, thereby allowing the crystal structure of the reprocessed perovskite compound to be successfully restored to the initial state immediately after synthesis.

The solvent may be any solvent having a polarity index of 5.5 to 7.5, without limitation so long as the solvent can dissolve components used in reprocessing of the perovskite compound. Specifically, the solvent may include at least one selected from the group consisting of 2-methoxyethanol, acetonitrile, acetic acid, dimethyl sulfoxide, γ-butyrolactone, and dimethylformamide.

Although preparation of the mixture may be carried out at room temperature, it should be understood that the present invention is not limited thereto and preparation of the mixture may be carried out at a temperature of 30°C to 50°C, as needed.

In addition, to ensure more efficient reprocessing reaction, the prepared mixture may be filtered through a filter to remove any insufficiently dissolved precursor particles. Here, the filter may include a polyvinylidene difluoride (PVDF) filter, without being limited thereto.

In one embodiment, the organic cation precursor may be an organic ammonium compound, wherein the organic ammonium compound may be a compound represented by Formula 2:

$$AX,$$

where A is formamidinium (FA), methylammonium (MA), $FA_xMA_{(1-x)}$ (where 0<x<1), or $N(R^1)4^+$, $R^1$ being a linear $C_1$ to $C_5$ alkyl group, a branched $C_3$ to $C_5$ alkyl group, a phenyl group, an alkylphenyl group, or an alkoxyphenyl group.

In Formula 2, X is a halogen anion, wherein the halogen anion may include $F^-$, $Cl^-$, $Br^-$, $I^-$, or a mixture thereof.

<u>(c) Step of reprocessing the degraded perovskite compound by heating the mixture prepared in step (b)</u>

The degraded perovskite compound is reprocessed by placing the mixture prepared in step (b) in a solvent, followed by heating.

The reprocessing reaction may be carried out at a temperature of 30°C to 300°C, preferably 50°C to 200°C, and more preferably 100°C to 150°C.

The reprocessing reaction may be carried out for 10 min to 180 min, preferably for 15 min to 120 min, more preferably for 20 min to 60 min.

When the reprocessing reaction is carried out at a temperature within this range for a period of time within this range, the crystal structure of the reprocessed perovskite compound can be successfully restored to the initial state immediately after synthesis, thereby allowing the reprocessed perovskite compound to exhibit performance similar to initial performance thereof.

In one embodiment, the solvent to which the mixture prepared in step (b) will be added may be preheated. The solvent may be preheated to a temperature of 30°C to 300°C, preferably 50°C to 200°C, more preferably 100°C to 150°C, still more preferably to a temperature at which reprocessing of the degraded perovskite compound is carried out.

Upon addition of the mixture prepared in step (b) in the preheated solvent, it is desirable that the mixture be added to the solvent as slowly as possible. For example, the mixture may be added to the solvent at a rate of 0.5 ml/min to 2.0 ml/min. If the mixture is added to the solvent all at once, a portion of the mixture can stick to walls of a reaction vessel, making smooth reprocessing reaction difficult, and the temperature of the solvent can rapidly decrease, making it difficult to maintain the temperature of the solvent at a level required for the reprocessing reaction, resulting in difficulty in obtaining a high-quality reprocessed perovskite compound. Conversely, when the mixture is added to the solvent slowly, the reprocessing reaction can begin immediately upon addition of the degraded perovskite compound, thereby allowing the crystal structure of the reprocessed perovskite compound to be successfully restored to the initial state immediately after synthesis and thus enabling obtainment of a high-quality reprocessed perovskite compound.

In one embodiment, the method of preparing a reprocessed perovskite compound may further include, after step (c), adding an antisolvent to induce precipitation of the reprocessed perovskite compound, followed by separation of a resulting precipitate. Separation of the precipitate may be carried out by any typical liquid-solid separation method known in the art, for example, centrifugation.

The antisolvent can precipitate the perovskite compound due to a polarity difference with the solvent and may include any antisolvent without limitation so long as a polarity index of the antisolvent differs from that of the solvent by 1 to 5. Specifically, the antisolvent may include at least one selected from the group consisting of: aromatic solvents, such as chlorobenzene, benzene, xylene, toluene, and dichlorobenzene; aliphatic solvents, such as diethyl ether, tetrahydrofuran (THF), 1,4-dioxane, hexane, isopropyl alcohol, and ethanol; and halogenated hydrocarbon solvents, such as chloroform and methylene chloride.

In one embodiment, the method of preparing a reprocessed perovskite compound may further include, after the step of separating the reprocessed perovskite compound, washing the separated reprocessed perovskite compound, followed by drying.

Washing of the reprocessed perovskite compound may be carried out using an antisolvent, for example, diethyl ether, without being limited thereto.

Drying of the reprocessed perovskite compound may be carried out under a vacuum and, if necessary, may involve heating to accelerate evaporation of the solvent.

# EP 4 750 298 A1

<Reprocessed perovskite compound, Perovskite device, and Solar cell>

The present invention provides a reprocessed perovskite compound prepared by the method of preparing a reprocessed perovskite compound described above.

The reprocessed perovskite compound according to the invention is prepared by the method of preparing a reprocessed perovskite compound described above. For details thereof, see <Method of preparing a reprocessed perovskite compound>.

In addition, the present invention provides a perovskite device including the reprocessed perovskite compound set forth above. The perovskite device may include a photosensor device, a light-emitting diode device, or a photovoltaic device, without being limited thereto.

In one embodiment, the perovskite device may have a power conversion efficiency (PCE) of 19.6% or more.

In another embodiment of the invention, the perovskite device may have a PCE corresponding to 95% or more, preferably 97% or more, relative to the initial PCE of a perovskite device including a freshly synthesized perovskite compound.

The power conversion efficiency (PCE) of the reprocessed perovskite device may be calculated according to Equation 1:

$$PCE(\%) = \frac{P_{OUT}}{P_{IN}} \times 100 = \frac{V_{OC} \times J_{SC} \times FF}{P_{IN}} \times 100$$

$$(1)$$

where $P_{OUT}$ is a maximum power output, $P_{IN}$ is an incident light power, $V_{OC}$ is an open-circuit voltage, $J_{SC}$ is a short-circuit current, and FF is a fill factor.

The fill factor (FF) may be calculated according to Equation 2:

$$FF = \frac{V_{MPP} \times J_{MPP}}{V_{OC} \times J_{SC}}$$

$$(2)$$

where $V_{MPP}$ and $J_{MPP}$ are voltage and current values corresponding to a maximum power position on a J-V curve, respectively, and $V_{OC}$ and $J_{SC}$ are as defined above.

In addition, the present invention provides a solar cell including the perovskite device set forth above. The solar cell is prepared using a high-performance reprocessed perovskite compound obtained by restoring a degraded perovskite compound to recover initial performance thereof. In this way, the present invention can provide a high-performance solar cell while reducing manufacturing costs.

Next, the present invention will be described in more detail with reference to some examples. However, it should be noted that these examples are provided for illustration only and are not to be construed in any way as limiting the present invention.

<EXAMPLE>

Preparative Example 1: Preparation of organic ammonium-based perovskite compound

An organic ammonium-based perovskite compound was prepared by the following method.

(1) Preparation of precursor

The following materials were used as perovskite precursors: lead iodide ($PbI_2$) and formamidinium iodide (FAI).

(2) Preparation of perovskite precursor solution

$PbI_2$ and FAI prepared in (1) were dissolved in 2-methoxyethanol (2-ME) as a solvent capable of dissolving the perovskite precursors.

8

(3) Synthesis of perovskite compound

The solution containing dissolved $PbI_2$ and FAI was filtered through a filter, followed by heating the filtered solution to 120°C for 30 minutes, thereby synthesizing a perovskite compound.

(4) Addition of antisolvent and precipitation of photoactive layer material

Chlorobenzene as an antisolvent was added to the solution of the synthesized perovskite compound to precipitate the perovskite compound.

(5) Washing of perovskite compound

The solution containing the precipitated perovskite compound was cooled, followed by washing the precipitated perovskite compound using diethyl ether as an antisolvent.

(6) Filtration of perovskite compound solution

The solution containing the washed perovskite compound was filtered for purification, followed by evaporating the solvent under a vacuum at 25°C for 12 hr.

(7) Obtainment of photoactive layer material

Finally, a formamidinium-based perovskite compound (formamidinium lead iodide ($FAPbI_3$)) was obtained in the form of a purified black powder (BP).

Experimental Example 1: Induced degradation of perovskite compound under high temperature/high humidity conditions and property analysis

Perovskite compounds obtained in Preparative Example 1 were exposed to high temperature/high humidity conditions of 85°C and 85% RH for 0 hr (pristine), 1 hr, 24 hr, 48 hr, 72 hr, and 100 hr, respectively, to induce degradation thereof.

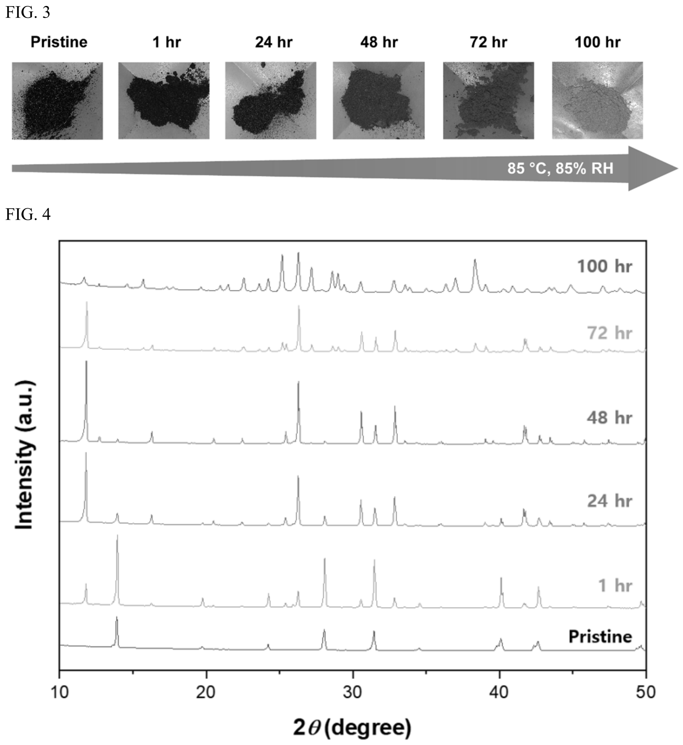

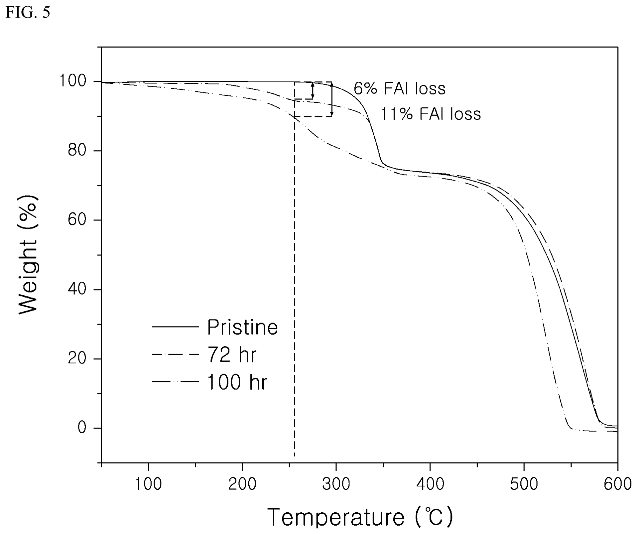

FIG. 3 is a digital image showing a degradation process over the period of exposure to high temperature/high humidity conditions, and FIG. 4 and FIG. 5 show the results of XRD analysis and TGA for each of the degraded perovskite compounds, respectively.
Referring to FIG. 3, it can be seen that, the perovskite compound immediately after synthesis, corresponding to 0 hr of exposure to the high temperature/high humidity conditions, was in the form of a deep black powder, the black color gradually faded with increase in the period of exposure, and, after 100 hr of exposure, a yellowish color was observed, indicating that significant degradation had occurred.
Referring to FIG. 4, it can be seen that, as the period of exposure to the high temperature/high humidity conditions increased, an initial crystal structure immediately after synthesis collapsed and a new phase with a different crystal structure was formed.
A method of determining a loss of FAI from TGA results will be described in detail using the formamidinium-based perovskite compound (formamidinium lead iodide ($FAPbI_3$)) obtained in Preparative Example 1 as an example. In a degraded perovskite compound, two types of FAI are present: FAI interacting with a perovskite structure and FAI liberated from the perovskite structure due to degradation. The FAI liberated by degradation begins to thermally decompose at about 250°C, while the FAI interacting with the perovskite structure begins to thermally decompose at a slightly higher temperature, about 270°C. Accordingly, based on a weight loss occurring near 250°C, the amount of FAI liberated from the perovskite structure due to degradation can be determined and this value may be used as a measure of the degree of degradation of the perovskite compound.
Referring to FIG. 5, it can be seen that, for the perovskite compound exposed to the high temperature/high humidity conditions for 48 hr or less, the loss of FAI was less than 1 wt% relative to the weight of FAI immediately after synthesis, indicating that little or no degradation occurred. Conversely, for the perovskite compound exposed to the high temperature/high humidity conditions for 72 hr, the loss of FAI was about 6 wt% relative to the weight of FAI immediately after synthesis and, for the perovskite compound exposed to the high temperature/high humidity conditions for 100 hr, the loss of FAI was about 11 wt% relative to the weight of FAI immediately after synthesis, indicating that degradation occurred in both cases.

Preparative Examples 2 to 7: Manufacture of perovskite device using perovskite compound exposed to high temperature/high humidity conditions

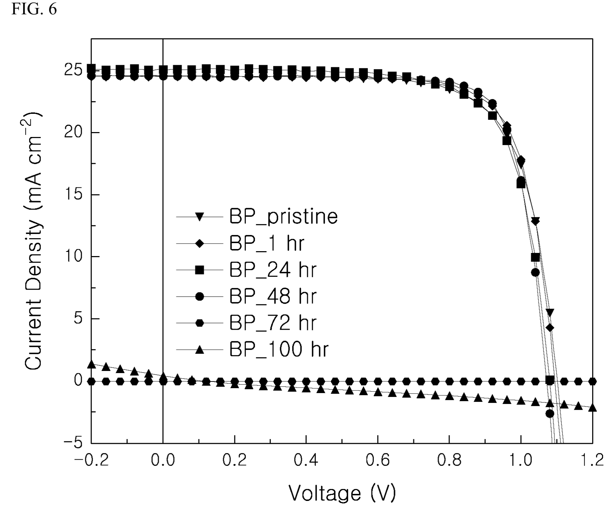

Perovskite devices (Preparative Examples 2 to 7) with a size of 0.09 cm$^2$ were prepared using the degraded perovskite compounds, respectively. Photocurrent-voltage (J-V) characteristics of each perovskite device were analyzed and results are shown in Table 1 and FIG. 6.

Table 1

| | Period of exposure to high temperature/high humidity conditions (hr) | VOC (V) | JSC (mA·cm$^{-2}$) | FF | PCE (%) |
|---|---|---|---|---|---|
| Preparative Example 2 | 0 (pristine) | 1.10 | 24.45 | 0.74 | 19.96 |
| Preparative Example 3 | 1 | 1.09 | 24.45 | 0.76 | 20.45 |
| Preparative Example 4 | 24 | 1.08 | 24.90 | 0.74 | 19.99 |
| Preparative Example 5 | 48 | 1.07 | 24.50 | 0.78 | 20.58 |
| Preparative Example 6 | 72 | - | - | - | - |
| Preparative Example 7 | 100 | - | - | - | - |

Referring to Table 1 and FIG. 6, it can be seen that the perovskite devices according to Preparative Examples 2 to 5, prepared using perovskite compounds exposed to the high temperature/high humidity conditions for 0 hr, 1 hr, 24 hr, and 48 hr, respectively, exhibited characteristics similar to those of a perovskite device prepared using a freshly synthesized perovskite compound.

Conversely, the photocurrent-voltage (J-V) characteristics of the perovskite devices according to Preparative Examples 6 and 7, prepared using perovskite compounds exposed to the high temperature/high humidity conditions for 72 hr and 100 hr, respectively, could not be measured due to degradation of perovskite compounds.

Examples 1 and 2 and Comparative Examples 1 to 3: Preparation of reprocessed perovskite compound

Reprocessed perovskite compounds were prepared using degraded perovskite compounds prepared through exposure to the high temperature/high humidity conditions for 72 hr and 100 hr, respectively. Table 2 shows the loss of FAI determined from TGA results and the amount of FAI added during reprocessing reaction.

Table 2

| | Period of exposure to high temperature/high humidity conditions (hr) | Loss of FAI | Amount of FAI added during reprocessing reaction |
|---|---|---|---|
| Example 1 | 72 | 6% of weight immediately after synthesis | - |
| Example 2 | 100 | 11% of weight immediately after synthesis | 100 wt% relative to loss of FAI |
| Comparative Example 1 | 72 | 6% of weight immediately after synthesis | 100 wt% relative to loss of FAI |
| Comparative Example 2 | 100 | 11% of weight immediately after synthesis | - |
| Comparative Example 3 | 100 | 11% of weight immediately after synthesis | 200 wt% relative to loss of FAI |

Each of the degraded perovskite compounds prepared through exposure to the high temperature/high humidity conditions for 72 hr and 100 hr was mixed in 2-methoxyethanol with FAI added in an amount shown in Table 2, followed by heating the resulting mixed solution to 120°C for 30 min, thereby preparing reprocessed perovskite compounds.

Experimental Example 2: SEM and XRD Analyses of reprocessed perovskite compounds

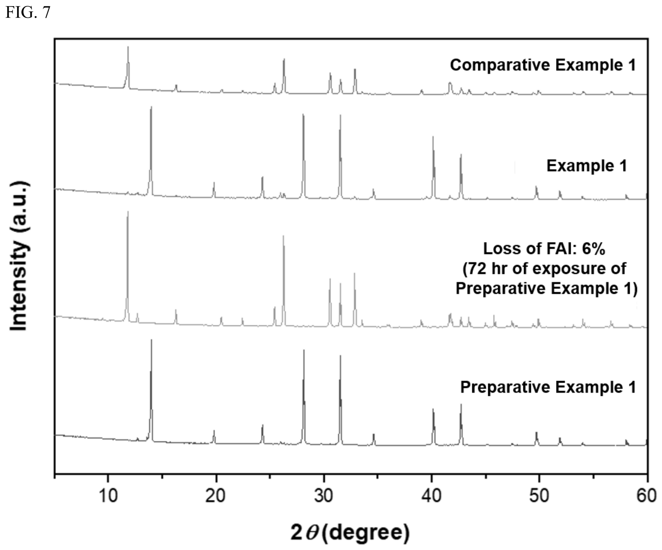

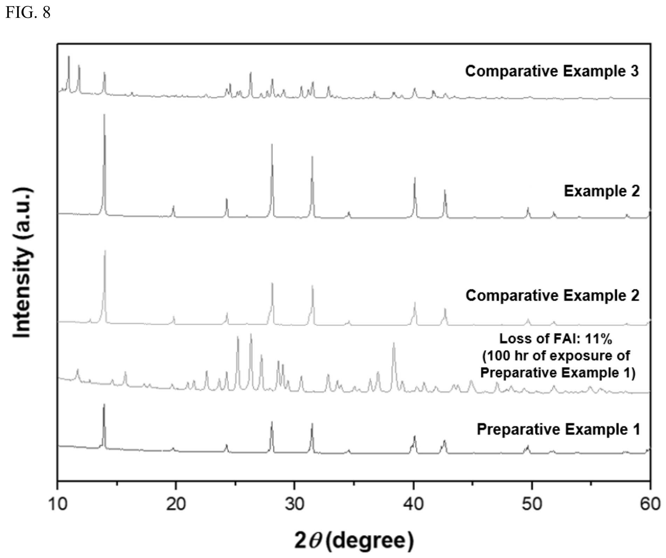

XRD analysis was performed on each of the reprocessed perovskite compounds and results are shown in FIG. 7 and FIG. 8.

Referring to FIG. 7, it can be seen that the reprocessed perovskite compound according to Example 1 showed results similar to those in Preparative Example 1 even without addition of FAI during reprocessing, indicating that the perovskite nanocrystalline structure was restored to the initial state immediately after synthesis. Conversely, it can be seen that the reprocessed perovskite compound according to Comparative Example 1, prepared by adding FAI during reprocessing, failed to have an $\alpha$-phase ($2\theta=13.9°$) that appears in the initial perovskite nanocrystalline structure immediately after synthesis.

Referring to FIG. 8, it can be seen that the reprocessed perovskite compound according to Example 2, prepared by adding FAI in an amount equivalent to the weight loss thereof during reprocessing, showed results similar to those in Preparative Example 1, indicating that the perovskite nanocrystalline structure was restored to the initial state immediately after synthesis. Conversely, it can be seen that, in the reprocessed perovskite compound according to Comparative Example 2, prepared without adding FAI during reprocessing, a $PbI_2$ peak ($2\theta=12.7°$) resulting from decomposition of the nanocrystalline structure was observed, indicating that the perovskite nanocrystalline structure was not fully restored to the initial state immediately after synthesis. In addition, it can be seen that the reprocessed perovskite compound according to Comparative Example 3, prepared by adding FAI in an amount corresponding to 200 wt% of the weight loss thereof during reprocessing, had extra, unwanted structures, in addition to the perovskite nanocrystalline structure immediately after synthesis.

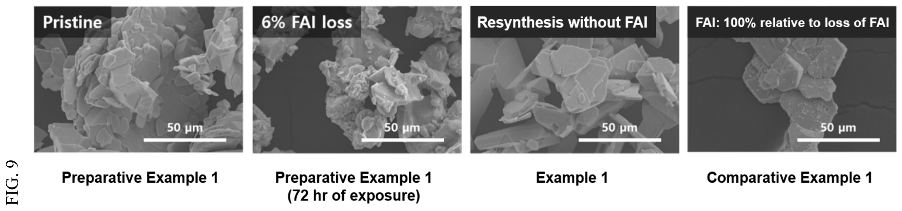

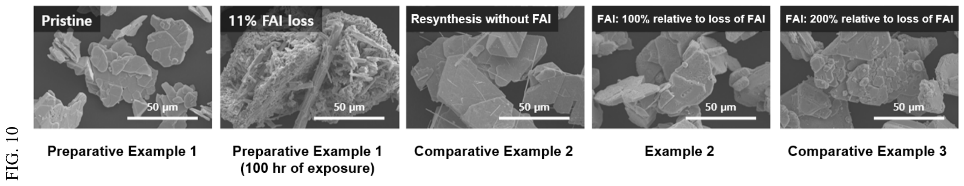

SEM images were taken of the reprocessed perovskite compounds and results are shown in FIG. 9 and FIG. 10.

Referring to FIG. 9, it can be seen that the reprocessed perovskite compound according to Example 1 had a structure very similar to that of the freshly synthesized perovskite compound according to Preparative Example 1, indicating that the crystal structure thereof was successfully restored to the initial state immediately after synthesis. Conversely, it can be seen that the reprocessed perovskite compound according to Comparative Example 1 had small particles attached to a surface thereof during reprocessing, indicating that the crystal structure thereof was not successfully restored to the initial state immediately after synthesis. The result for Comparative Example 1 likely occurred because FAI was added during reprocessing even though the loss of FAI was less than the reference value, leading to the presence of an excess of FAI in the reprocessing reaction.

Referring to FIG. 10, it can be seen that the reprocessed perovskite compound according to Example 2 had a structure very similar to that of the freshly synthesized perovskite compound according to Preparative Example 1, indicating that the crystal structure thereof was successfully restored to the initial state immediately after synthesis. Conversely, it can be seen that the reprocessed perovskite compound according to Comparative Example 2 still had long, cylindrical $PbI_2$ impurities and the reprocessed perovskite compound according to Comparative Example 3 had extra, unwanted structures. The result for Comparative Example 2 likely occurred because FAI was not added during reprocessing even though the loss of FAI was greater than or equal to the reference value, leading to precipitation of residual $PbI_2$ that could not form a nanocrystalline structure. The result for Comparative Example 3 likely occurred because FAI was added in an excessive amount relative to the loss of FAI, leading to the presence of an excess of FAI in the reprocessing reaction.

Accordingly, the analysis results of the SEM images in FIG. 9 and FIG. 10 showed a trend consistent with the XRD analysis results in FIG. 7 and FIG. 8.

Experimental Example 3: Analysis of photocurrent-voltage (J-V) characteristics of perovskite devices prepared using reprocessed perovskite compounds

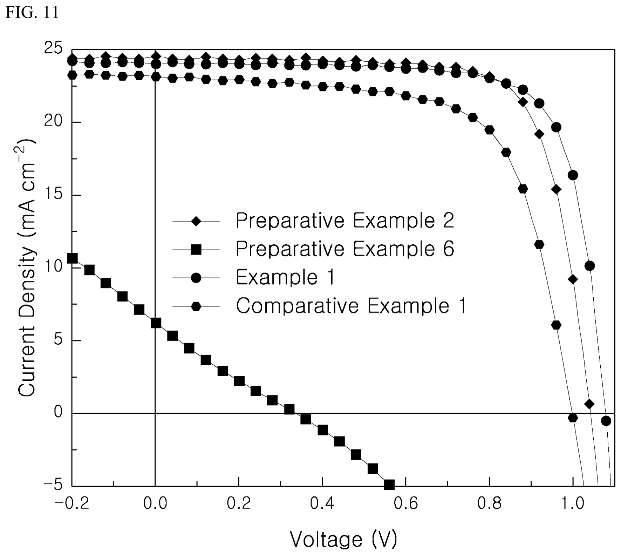

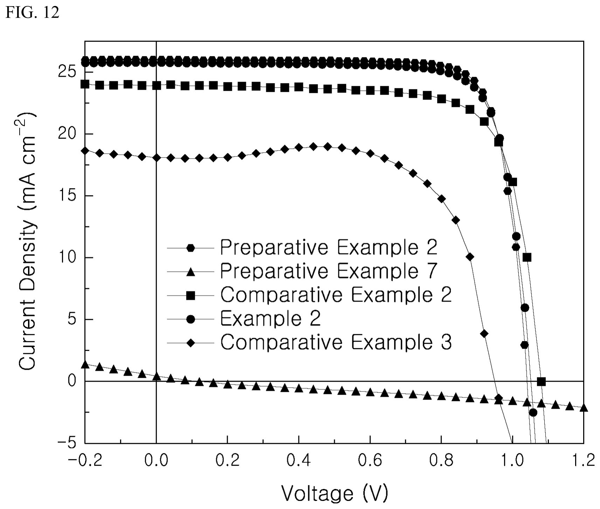

Perovskite devices with a size of 0.09 cm$^2$ were prepared using the reprocessed perovskite compounds according to Examples and Comparative Examples, respectively, and the photocurrent-voltage (J-V) characteristics of each perovskite device were analyzed. Results are shown in Table 3, FIG. 11, and FIG. 12.

Table 3

|  | VOC (V) | JSC (mA·cm$^{-2}$) | FF | PCE (%) |
|---|---|---|---|---|
| Preparative Example 2 | 1.06 | 24.91 | 0.76 | 20.14 |
| Example 1 | 1.08 | 23.93 | 0.76 | 19.66 |
| Example 2 | 1.05 | 25.74 | 0.78 | 21.18 |
| Comparative Example 1 | 0.99 | 22.72 | 0.69 | 15.54 |

(continued)

|  | VOC (V) | JSC (mA·cm$^{-2}$) | FF | PCE (%) |
|---|---|---|---|---|
| Comparative Example 2 | 1.07 | 23.00 | 0.72 | 18.16 |
| Comparative Example 3 | 0.94 | 18.46 | 0.72 | 12.43 |

Referring to Table 3, FIG. 11, and FIG. 12, it can be seen that the perovskite devices prepared using the reprocessed perovskite compounds according to Examples 1 and 2, respectively, exhibited characteristics similar to or superior to those of the perovskite device according to Preparative Example 2, prepared using a freshly synthesized perovskite compound. Conversely, the perovskite devices prepared using the reprocessed perovskite compounds according to Comparative Examples 1 to 3, respectively, showed results that fell short of initial performance immediately after synthesis, which likely occurred because the crystal structures of these reprocessed perovskite compounds were not successfully restored to the initial state immediately after synthesis.

**Claims**

1. A method of preparing a reprocessed perovskite compound, comprising:

   (a) determining a weight loss of a degraded perovskite compound;
   (b) preparing a mixture by mixing the degraded perovskite compound with a solvent; and
   (c) reprocessing the degraded perovskite compound by heating the mixture prepared in step (b),

   wherein, when the weight loss of the degraded perovskite compound as determined in step (a) is greater than or equal to a reference value, step (b) further comprises adding 50 wt% to 180 wt% of an organic cation precursor relative to the weight loss.

2. The method according to claim 1, wherein the perovskite compound is an organic ammonium-based perovskite compound.

3. The method according to claim 2, wherein the organic ammonium-based perovskite compound is a compound represented by Formula 1:

   $$AMX_3,$$

   where A is formamidinium (FA), methylammonium (MA), $FA_xMA_{(1-x)}$ ($0<x<1$), or $N(R^1)4^+$, $R^1$ being a linear $C_1$ to $C_5$ alkyl group, a branched $C_3$ to $C_5$ alkyl group, a phenyl group, an alkylphenyl group, or an alkoxyphenyl group; M is a divalent metal cation; and X is a halogen anion.

4. The method according to anyone of claims 1 to 3, wherein the degraded perovskite compound has a weight loss of 1 wt% or more relative to a weight of the perovskite compound immediately after synthesis.

5. The method according to anyone of claims 1 to 4, wherein the reference value is selected within a range of 6% to 10% of a weight of the perovskite compound immediately after synthesis.

6. The method according to anyone of claims 1 to 5, wherein, in step (a), the weight loss is determined by thermogravimetric analysis (TGA).

7. The method according to anyone of claims 1 to 6, wherein the organic cation precursor is an organic ammonium compound.

8. The method according to claim 7, wherein the organic ammonium compound is a compound represented by Formula 2:

AX,

where A is formamidinium (FA), methylammonium (MA), $FA_xMA_{(1-x)}$ (0<x<1), or $N(R^1)4^+$, $R^1$ being a linear $C_1$ to $C_5$ alkyl group, a branched $C_3$ to $C_5$ alkyl group, a phenyl group, an alkylphenyl group, or an alkoxyphenyl group; and
X is a halogen anion.

9. The method according to anyone of claims 1 to 8, wherein step (c) is performed at a temperature of 30°C to 300°C for 10 min to 180 min.

10. A reprocessed perovskite compound prepared by the method according to anyone of claims 1 to 9.

11. A perovskite device comprising the reprocessed perovskite compound according to claim 10.

12. A solar cell comprising the perovskite device according to claim 11.

FIG. 1

FIG. 2

FIG. 3

85 °C, 85% RH

FIG. 4

FIG. 5

FIG. 6

FIG. 7

FIG. 8

FIG. 9

Pristine

Preparative Example 1

6% FAI loss

Preparative Example 1
(72 hr of exposure)

Resynthesis without FAI

Example 1

FAI: 100% relative to loss of FAI

Comparative Example 1

FIG. 10

FIG. 11

FIG. 12

**EUROPEAN SEARCH REPORT**

Application Number

EP 25 21 8282

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HUANG YI-YOU ET AL: "Rejuvenation of perovskite solar cells", JOURNAL OF MATERIALS CHEMISTRY C, vol. 4, no. 32, 1 January 2016 (2016-01-01), pages 7595-7600, XP093357787, GB ISSN: 2050-7526, DOI: 10.1039/C6TC02307J | 10-12 | INV. H10K85/50 ADD. H10K30/40 H10K30/50 |
| A | * Page 7596: Rejuvenation method; figure 4 * | 1-9 | |
| X | DAO QUANG-DUY ET AL: "Study on degradation mechanism of perovskite solar cell and their recovering effects by introducing CH3NH3I layers", ORGANIC ELECTRONICS ELSEVIER, AMSTERDAM, NL, vol. 43, 27 January 2017 (2017-01-27), pages 229-234, XP029925972, ISSN: 1566-1199, DOI: 10.1016/J.ORGEL.2017.01.038 | 10-12 | |
| A | * abstract * | 1-9 | TECHNICAL FIELDS SEARCHED (IPC) H10K |
| X | LI ZHEN ET AL: "A methylammonium iodide healing method for CH sub 3 /sub NH sub 3 /sub PbI sub 3 /sub perovskite solar cells with high fill factor over 80%", JOURNAL OF SEMICONDUCTORS, vol. 42, no. 11, 1 November 2021 (2021-11-01), page 112202, XP093378978, GB; CN ISSN: 1674-4926, DOI: 10.1088/1674-4926/42/11/112202 | 10-12 | |
| A | * abstract; figure 1 * | 1-9 | |

-/--

The present search report has been drawn up for all claims

| Place of search | Date of completion of the search | Examiner |
|---|---|---|
| The Hague | 23 March 2026 | Welter, Steve |

EPO FORM 1503 03.82 (P04C01)

page 1 of 2

Europäisches
Patentamt

European
Patent Office

Office européen
des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JINGXUAN CHEN ET AL: "Rejuvenating Aged Perovskite Quantum Dots for Efficient Solar Cells", ADVANCED MATERIALS VCH PUBLISHERS, DE, vol. 36, no. 1, 20 November 2023 (2023-11-20), pages n/a-n/a, XP072562483, ISSN: 0935-9648, DOI: 10.1002/ADMA.202306854 | 10-12 | |
| A | * abstract; figure 1 * | 1-9 | |

-----

TECHNICAL FIELDS
SEARCHED (IPC)

The present search report has been drawn up for all claims

| Place of search | Date of completion of the search | Examiner |
|---|---|---|
| The Hague | 23 March 2026 | Welter, Steve |

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240170589